Europäisches Patentamt

European Patent Office

Office européen des brevets

(19)

(11) EP 0 767 917 B1

(12) EUROPÄISCHE PATENTSCHRIFT

(45) Veröffentlichungstag und Bekanntmachung des Hinweises auf die Patenterteilung:
25.03.1998 Patentblatt 1998/13

(51) Int Cl.6: G01R 19/02

(21) Anmeldenummer: 95924838.6

(86) Internationale Anmeldenummer:
PCT/DE95/00874

(22) Anmeldetag: 27.06.1995

(87) Internationale Veröffentlichungsnummer:
WO 96/00906 (11.01.1996 Gazette 1996/03)

(54) **VERFAHREN ZUM DIGITALEN BESTIMMEN DES EFFEKTIVWERTES EINES PERIODISCHEN ELEKTRISCHEN MESSSIGNALS**

DIGITAL PROCESS FOR DETERMINING THE EFFECTIVE VALUE OF A PERIODIC ELECTRIC MEASUREMENT SIGNAL

PROCEDE NUMERIQUE DE DETERMINATION DE LA VALEUR EFFICACE DE SIGNAUX ELECTRIQUES PERIODIQUES DE MESURE

(84) Benannte Vertragsstaaten:
DE FR GB

(30) Priorität: 28.06.1994 DE 4423763

(43) Veröffentlichungstag der Anmeldung:
16.04.1997 Patentblatt 1997/16

(73) Patentinhaber: SIEMENS AKTIENGESELLSCHAFT
80333 München (DE)

(72) Erfinder:
• RECK, Thomas
  D-12205 Berlin (DE)
• SEZI, Tevfik
  D-12169 Berlin (DE)

(56) Entgegenhaltungen:
DE-A- 3 222 087        DE-A- 3 928 083
DE-A- 4 122 399

**Beschreibung**

Es ist unter anderem aus dem Buch von H. Germer und N. Wefers "Meßelektronik", Band 2, 2. Auflage, 1990, Seite 15 bekannt, daß sich auf digitale Weise über Abtastwerte eines periodischen elektrischen Meßsignals der Effektivwert des Meßsignals nach folgender Gleichung (1) bestimmen laßt:

$$I = \sqrt{\frac{1}{N}\sum_{k=0}^{N-1} i^2(k)} \qquad\qquad (1)$$

In dieser Gleichung bezeichnet I den Effektivwert des periodischen elektrischen Meßsignals, N die Anzahl der Abtastungen pro Periodendauer des elektrischen Meßsignals und i(k) den jeweiligen Abtastwert.

Aus dem genannten Buch ist es ferner bekannt, daß sich verhältnismäßig große Fehler beim Bestimmen des Effektivwertes eines periodischen elektrischen Meßsignals dann ergeben, wenn die Abtastintervalldauer von der Periodendauer des Meßsignals stark abweicht. Um dennoch bei den Unterschieden zwischen Abtastintervall- und Periodendauer den Effektivwert eines periodischen elektrischen Meßsignals mit relativ hoher Genauigkeit bestimmen zu können, ist es aus der DE 41 22 399 A1 bekannt, das Abtastintervall in bezug auf das elektrische Meßsignal um jeweils einen Taktzyklus zu verschieben und aus den jeweils so gewonnenen Abtastwerten jeweils entsprechende Effektivwerte zu ermitteln. Aus den so gewonnenen Effektivwerten wird ein Mittelwert bestimmt, der frequenzunabhängig den Effektivwert des Meßsignals angibt.

Die Erfindung geht von einem Verfahren zum digitalen Bestimmen des Effektivwertes eines periodischen elektrischen Meßsignals aus, bei dem das Meßsignal während einer von der Periodendauer des Meßsignals abweichenden Abtastintervall-Dauer abgetastet wird, die Abtastwerte nach Analog-Digital-Wandlung in einem Rechenbaustein quadriert, aufsummiert und gemittelt werden und aus dem sich ergebenden Mittelwert die Quadratwurzel gezogen wird, und stellt sich die Aufgabe, schnell - nach einer Periode des Meßsignals - und mit hoher Genauigkeit den Effektivwert des periodischen elektrischen Signals zu bestimmen.

Zur Lösung dieser Aufgabe erfolgt erfindungsgemäß bei einer zwei Perioden des elektrischen Meßsignals entsprechenden Abtastintervall-Dauer mit einer ungeraden Zahl M von Abtastungen bei N in eine Periode des Meßsignals fallenden Abtastwerten eine Quadrierung und Aufsummierung der Werte bis einschließlich des (N)-ten Abtastwertes; zu der so gebildeten Summe wird unter Bildung einer Zwischengröße ein Betrag als Korrekturgröße addiert, der der Hälfte des Quadrates aus einer Hilfsgröße entspricht, die aus einem Viertel des N-ten Abtastwertes und aus drei Vierteln des (N+1)-ten Abtastwertes durch Summation gebildet ist, wobei N = (M-1)/2 ist; der Mittelwert wird durch Division der Zwischengröße durch die Anzahl M/2 gebildet.

Der wesentliche Vorteil des erfindungsgemäßen Verfahrens besteht darin, daß trotz eines Unterschiedes zwischen der Abtastintervall- und der Periodendauer des Meßsignals bereits nach einer Periode des elektrischen Meßsignals der Effektivwert des periodischen elektrischen Meßsignals mit hoher Genauigkeit bestimmbar ist, weil der sich nach einer Periode des elektrischen Meßsignals aus den Abtastwerten ohne weiteres errechenbare (fehlerbehaftete) Effektivwert korrigiert wird. Damit lassen sich in vorteilhafter Weise Abtastwerte zur Effektivwertbestimmung heranziehen, die im Hinblick auf andere Meßaufgaben bezüglich des periodischen elektrischen Meßsignals so gebildet sind, daß eine Abtastung mit einem nichtganzzahligen Mehrfachen der Frequenz der Grundschwingung des Meßsignals erfolgt, um Oberschwingungen höherer Art ermitteln zu können (vgl. Anmeldung WO 95/33211).

Zur Erläuterung der Erfindung wird davon ausgegangen, daß beispielsweise bei einem periodischen elektrischen Meßsignal, das aus dem Strom oder der Spannung in einem elektrischen Energieversorgungsnetz abgeleitet ist, während zwei Perioden der Netzgrößen M Abtastungen vorgenommen werden, wobei M ganzzahlig und ungerade ist. Kann im Hinblick auf eine notwendige schnelle Ermittlung eines Effektivwertes nur eine Meßdauer von einer Netzperiode zugelassen werden, dann ergibt sich rein mathematisch für N Abtastungen pro Periode

$$N = M/2 \qquad\qquad (2)$$

Macht man ferner bei aus Netzströmen oder Netzspannungen gewonnenen periodischen elektrischen Meßsignalen den zulässigen Ansatz, daß i(k) durch folgende Beziehung (3) dargestellt werden kann

$$i(k) = \cos\left(\frac{4\pi k}{M} + \varphi\right), \qquad\qquad (3)$$

und setzt man die Beziehung (3) in die Gleichung (1) ein, dann ergibt sich nach einer elementaren Rechnung die Gleichung (4)

$$I_N = \sqrt{\frac{2}{M}\left[\frac{N}{2} + \frac{1}{2}\cos\left(\frac{4\pi}{M}(N-1) + 2\varphi\right)\frac{\sin\frac{4\pi}{M}N}{\sin\frac{4\pi}{M}}\right]} \qquad\qquad (4)$$

Für N = M/2 folgt aus der Gleichung (4) für den Effektivwert

$$I_N = I = \sqrt{\frac{2}{M}\left[\frac{M}{4}\right]} \qquad\qquad (5)$$

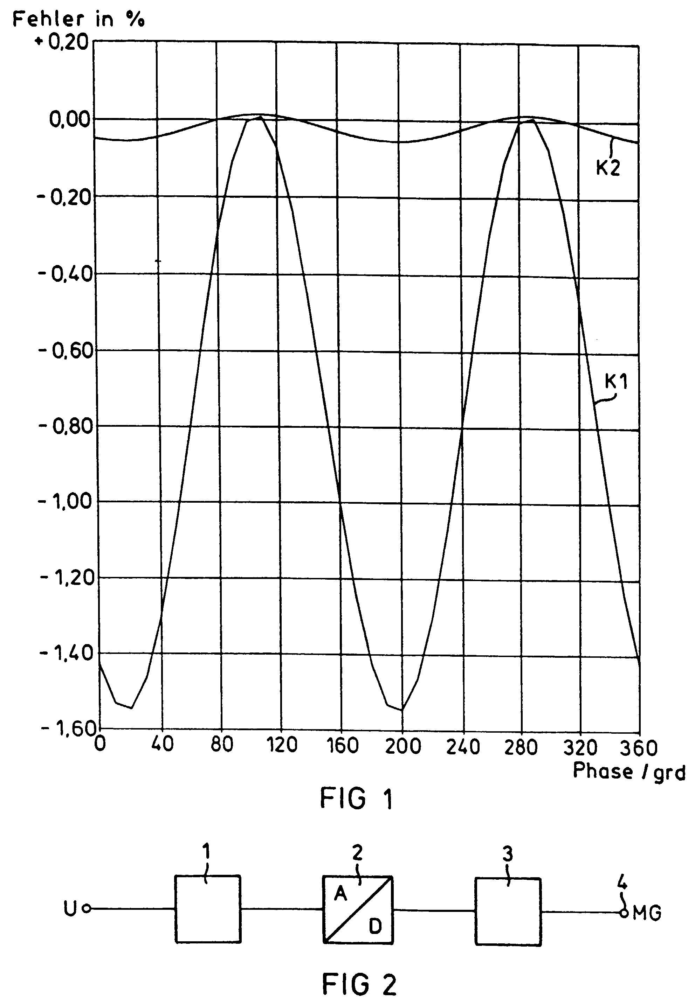

Wählt man beispielsweise M = 33, werden also in zwei Perioden eines aus einem Netzstrom oder einer Netzspannung abgeleiteten periodischen elektrischen Meßsignals 33 Abtastungen vorgenommen, dann würde sich der in Gleichung (5) angegebene Effektivwert nur dann ermitteln lassen, wenn 16,5 Abtastungen pro Periode des elektrischen Meßsignals ausgewertet werden. Eine solche Zahl von Abtastungen läßt sich aber technisch nicht durchführen; beispielsweise können nur N = 16 Abtastungen in einer Periode berücksichtigt werden. Dann ergibt sich aber - wie eine Fehlerabschätzung zeigt - ein maximaler Fehler von 1,6 %, wie der Kurve K1 der Figur 1 entnehmbar ist. Ein solcher Fehler ist bei vielen Meßaufgaben nicht hinnehmbar.

Deshalb wird gemäß der Erfindung von folgender Gleichung (6) ausgegangen

$$I_{Kor} = \sqrt{\frac{2}{M} \cdot \left[\sum_{k=0}^{N-1} i^2(k) + KE\right]}, \qquad\qquad (6)$$

in der mit KE eine Korrekturgröße bezeichnet ist, die sich durch folgende Beziehung

$$KE = \frac{M}{4} - \left[\frac{N}{2} + \frac{1}{2}\cos\left(\frac{4\pi}{M}(N-1) + 2\varphi\right)\frac{\sin\frac{4\pi}{M}N}{\sin\frac{4\pi}{M}}\right] \qquad\qquad (7)$$

darstellen läßt. In dieser Gleichung (7) führt der Subtrahend M/4 zu dem sich mathematisch exakt bei - in dem angenommenen Beispiel - 16,5 Abtastungen in einer Periode ergebenden Effektivwert. Davon ist der Klammerausdruck abzuziehen, wenn N = 16 Abtastungen berücksichtigt werden.

Setzt man in die Gleichung (7) die Werte für M = 33 und N = 16 ein, dann ergibt sich für die Korrekturgröße KE eine Beziehung, wie sie in der nachfolgenden Gleichung (8) aufgeführt ist:

$$KE = \frac{1}{4} - \frac{1}{2}\cos\left(\frac{4\pi}{33}15 + 2\varphi\right)\frac{\sin\frac{4\pi}{33}16}{\sin\frac{4\pi}{33}} \tag{8}$$

Da der Quotient der beiden Sinuswerte in der Beziehung(8) etwa - 0,5 beträgt, kann die Korrekturgröße KE auch durch folgende Beziehung (9) ausgedrückt werden

$$KE \approx \frac{1}{4} + \frac{1}{4}\cos\left(\frac{4\pi}{33}15 + 2\varphi\right) = \frac{1}{2}\cos^2\left(\frac{4\pi}{33}7,5 + \varphi\right) = \frac{1}{2}i^2(k = 7,5) \tag{9}$$

Diese Gleichung (9) ist aber nicht ohne weiteres bei der Bestimmung des Effektivwertes verwendbar, weil ein Abtastwert bei k = 7,5 nicht vorliegt. Daher erfolgt eine Interpolation. Dabei wird, um auch bei geradzahligen Oberschwingungen den Effektivwert möglichst genau bestimmen zu können, folgende Periodizität ausgenutzt:

$$\frac{1}{2}i^2(7,5) = \frac{1}{2}\cos^2\left(\frac{4\pi}{33}7,5 + \varphi\right) = \frac{1}{2}\cos^2\left(\frac{4\pi}{33}7,5 + \pi + \varphi\right) = \frac{1}{2}\cos^2\left(\frac{4\pi}{33}15,75 + \varphi\right) = \frac{1}{2}i^2(15,75) \tag{10}$$

Da bei k = 15,75 ein Abtastwert nicht vorliegt, wird folgende Interpolation vorgenommen:

$$i(15,75) = 0,25i(15) + 0,75i(16) \tag{11}$$

Unter Berücksichtigung der Beziehung (6) kann dann für den korrigierten Effektivwert $I_{kor}$ folgende Beziehung aufgestellt werden

$$I_{kor} = \sqrt{\frac{\left[\sum_{k=0}^{15}i^2(k)\right] + \frac{1}{2}\left[0,25i(15) + 0,75i(16)\right]^2}{16,5}} \tag{12}$$

Figur 1 zeigt in Form der Kurve K2 den Verlauf des Fehlers bei der vorgenommenen Korrektur. Verallgemeinert ergibt sich die Korrekturgleichung

$$I_{kor} = \sqrt{\frac{2\left[\sum_{k=0}^{N-1}i^2(n)\right] + \left[\frac{1}{4}i(N-1) + \frac{3}{4}i(N)\right]^2}{M}} \tag{13}$$

Eine Anordnung zur Durchführung des erfindungsgemäßen Verfahrens enthält eingangsseitig eine Abtasteinrichtung 1, die an ihrem Eingang 2 mit einem periodischen elektrischen Meßsignal U beaufschlagt ist, dessen Effektivwert bestimmt werden soll. Der Abtasteinrichtung 1 ist ein Analog-Digital-Wandler 2 nachgeordnet, dem wiederum ein Rechenbaustein 3 nachgeordnet ist. In diesem Rechenbaustein 3 werden die von der Abtasteinrichtung 1 gelieferten Abtastwerte nach Digitalisierung quadriert, aufsummiert und gemittelt, wie es die obigen Beziehungen erkennen lassen. Es wird auch das Korrekturglied KE gebildet und somit am Ausgang 4 eine Meßgröße MG erzeugt, die den Effektivwert des elektrischen Meßsignals U am Eingang der Abtasteinrichtung 1 wiedergibt.

**Patentansprüche**

1. Verfahren zum digitalen Bestimmen des Effektivwertes eines periodischen elektrischen Meßsignals (U), bei dem

   - das Meßsignal (U) während einer von der Periodendauer des Meßsignals (U) abweichenden Abtastintervall-Dauer abgetastet wird,
   - die Abtastwerte nach Analog-Digital-Wandlung in einem Rechenbaustein (3) quadriert, aufsummiert und gemittelt werden und
   - aus dem sich ergebenden Mittelwert die Quadratwurzel gezogen wird,

   **dadurch gekennzeichnet**, daß

   - bei einer zwei Perioden des elektrischen Meßsignals (U) entsprechenden Abtastintervall-Dauer mit einer ungeraden Zahl M von Abtastungen bei N in eine Periode des Meßsignals (U) fallenden Abtastwerten eine Quadrierung und Aufsummierung der Werte bis einschließlich des N-ten Abtastwertes erfolgt,
   - zu der so gebildeten Summe unter Bildung einer Zwischengröße ein Betrag als Korrekturgröße (KE) addiert wird, der der Hälfte des Quadrates aus einer Hilfsgröße entspricht, die aus einem Viertel des N-ten Abtastwertes und aus drei Vierteln des (N+1)-ten Abtastwertes durch Summation gebildet ist, wobei

   $$- N = (M - 1)/2 \text{ ist,}$$

   und
   - der Mittelwert durch Division der Zwischengröße durch die Anzahl M/2 gebildet wird.

**Claims**

1. Method for digitally determining the r.m.s. value (effective value) of a periodic electrical measurement signal (U), in which method

   - the measurement signal (U) is sampled during a sampling-interval duration which deviates from the period of the measurement signal (U),
   - the sampled values are squared, summed up and averaged in an arithmetic block (3) after analog-to-digital conversion, and
   - the square root is drawn from the resulting mean value,

   characterised in that

   - in the case of a sampling-interval duration which corresponds to two periods of the electrical measurement signal (U), with an odd number M of samplings in the case of N sampled values falling in one period of the measurement signal (U), a squaring and summing up of the values up to and including the N-th sampled value takes place,
   - as a correcting variable (KE), there is added to the sum formed in this way, forming an intermediate variable, an amount which corresponds to half of the square of an auxiliary variable, which is formed by summation from one quarter of the N-th sampled value and from three-quarters of the (N+1)-th sampled value, with

   $$- N = (M-1)/2,$$

   and
   - the mean value is formed by dividing the intermediate value by the number M/2.

**Revendications**

1. Procédé de détermination numérique de la valeur réelle d'un signal (U) électrique périodique de mesure, dans lequel

   - on échantillonne le signal (U) de mesure pendant une durée d'intervalle d'échantillonnage différant de la durée de la période du signal (U) de mesure,
   - après conversion analogique-numérique, dans un module (3) de calcul, on élève au carré, on somme les valeurs d'échantillonnage et on en fait la moyenne et
   - on extrait la racine carrée de la valeur moyenne obtenue,

   caractérisé en ce que

   - pour une durée d'intervalle d'échantillonnage correspondant à deux périodes du signal (U) électriques de mesure, comportant un nombre M impair d'échantillonnages, pour N valeurs d'échantillonnage tombant pendant une période du signal (U) de mesure, on effectue une élévation au carré et une sommation des valeurs jusqu'à la N$^{ième}$ valeur d'échantillonnage incluse,
   - on additionne à la somme ainsi formée, moyennant la formation d'une valeur intermédiaire, une valeur comme valeur (KE) de correction qui correspond à la moitié du carré d'une valeur auxiliaire qui est formée par sommation d'un quart de la N$^{ième}$ valeur d'échantillonnage et de trois quart de la N+1$^{ième}$ valeur d'échantillonnage,
   - N étant égal à (M - 1)/2, et
   - la valeur moyenne étant formée en divisant la valeur intermédiaire par le nombre M/2.

FIG 1

FIG 2